# EUROPEAN PATENT APPLICATION

(11) **EP 4 633 335 A1**
(43) Date of publication of application: **15.10.2025**
(21) Application number: 24914479.1
(22) Date of filing: 26.11.2024
(51) Int. Cl.: H10K 30/88, H10K 71/00, H10K 30/80

(54) **PACKAGING LAYER STRUCTURE OF PEROVSKITE SOLAR CELL MODULE AND PACKAGING METHOD THEREOF**

(30) Priority: 18.01.2024 CN 202410073217
(71) Applicant: Xi'an TJ-Solar New Energy Co., Ltd, Xianyang, Shaanxi 712046 (CN)
(72) Inventor: LI, Peizhou, Xianyang, Shaanxi 712046 (CN); ZHAO, Changzheng, Xianyang, Shaanxi 712046 (CN)
(74) Representative: Berggren Oy
(86) International application number: PCT/CN2024/134585
(87) International publication number: WO 2025/152619

(57) **Abstract**

The invention belongs to the technical field of solar cell packaging, and relates to an encapsulation layer structure of a perovskite solar cell module and an encapsulation method of an encapsulation layer structure of a perovskite solar cell module. The packaging layer structure is obtained by an evaporation method with a simple process flow, is easy to manufacture and reduces production cost. A second inorganic layer at an uppermost portion of the perovskite solar cell module blocks oxygen, and a protective layer between the second inorganic layer and a metal electrode layer protects a structure and efficiency of a device. A first inorganic layer is arranged between an electron transport layer and the metal electrode layer, and can inhibit increase in defect state densities and non-radiative recombination caused by internal ion migration, increase an open-circuit voltage, play a positive role in improving energy conversion efficiency of the perovskite solar cell module, and can also play a role in blocking moisture. In addition, the perovskite cell module packaged by the packaging method according to the invention greatly improves stability against moisture and oxygen, and also improves work stability.

## Description

### Technical Field

The invention belongs to the technical field of the encapsulation of solar cell, relates to perovskite solar cell, and in particular to an encapsulation layer structure of a perovskite solar cell module and an encapsulation method of an encapsulation layer structure of a perovskite solar cell module.

### Background

At present, a basic structure of a perovskite solar cell module includes a hole transport layer (HTL), a perovskite layer, an electron transport layer (ETL), and an electrode that are manufactured sequentially on a substrate of transparent conductive glass (usually ITO or FTO). After the perovskite solar cell module is manufactured, a module device will degrade quickly and even fail if exposed to air for a long time due to its susceptibility to oxygen and moisture. Hence, the module device needs to be encapsulated to be isolated from the moisture and the oxygen and prolong its lifespan.

By an encapsulation method known to inventors, encapsulating adhesives are dispensed, and then covered with a cover plate and cured simultaneously. Due to a large contact area between the encapsulating adhesives and a substrate of a device or the cover plate, the moisture and the oxygen will permeate into an active layer of the device through a contact gap between the encapsulating adhesives and each of an upper substrate and a lower substrate, so as to affect a performance and an encapsulation effect of the device. Further, an encapsulation method for the encapsulating adhesives have high requirements for a quality and a dispensing and curing process of the adhesives, and residual bubbles in the adhesives or discontinuous coverage of the adhesive will lead to an unsatisfactory encapsulation effect.

In view of this, the present invention is provided.

### Summary

An objective of the invention is to overcome the shortcomings of the art known to the inventors and provide an encapsulation layer structure of a perovskite solar cell module and an encapsulation method of an encapsulation layer structure of a perovskite solar cell module, so as to prevent adverse effect on a perovskite layer caused by a fact that moisture and oxygen in air enters a device, further improve stability of a perovskite solar cell and prolong its lifespan.

In order to achieve the above objective, the invention provides the following technical solution:
In one aspect, the invention provides an encapsulation layer structure of a perovskite solar cell module. The encapsulation layer structure of a perovskite solar cell module includes a first inorganic layer, a metal electrode layer, a protective layer, and a second inorganic layer that are sequentially stacked on the perovskite solar cell module; where
the protective layer is made from at least one of alkali metal fluoride or alkaline earth metal fluoride.

Optionally, the alkali metal fluoride includes at least one of lithium fluoride, sodium fluoride, potassium fluoride, rubidium fluoride, and cesium fluoride, and
the alkaline earth metal fluoride includes at least one of beryllium fluoride, magnesium fluoride, calcium fluoride, strontium fluoride, and barium fluoride.

Further, the first inorganic layer is a metal oxide layer, and the metal oxide layer includes one or a mixture of more of silicon oxide (SiOₓ), zinc oxide (ZnO), aluminum oxide (AlOₓ), antimony trioxide (Sb₂O₃), molybdenum oxide (MoOₓ), tungsten oxide (WOₓ), indium oxide (In₂O₃), tin oxide (SnO₂), and indium tin oxide (ITO).

Further, the second inorganic layer includes one or more of aluminum, silver, zinc, nickel, and magnesium.

Further, the metal electrode layer includes one or more of gold (Au), silver (Ag), copper (Cu), and aluminum (Al) and a thickness of the metal electrode layer is 200 nm-400 nm.

Further, a thickness of the first inorganic layer is 2 nm-200 nm. The first inorganic layer is made from a mixture of molybdenum dioxide and molybdenum trioxide, or a mixture of tungsten dioxide and tungsten trioxide. The first inorganic layer formed by the mixture has a dense morphology, can prevent moisture from permeating, and effectively improve humidity stability and operational stability of a module device. In addition, because of a small thickness of the metal oxide layer, the metal oxide layer can transfer carriers well and cannot adversely affect an power conversion efficiency of the module device. In addition, the metal oxide layer can block migration of I⁻ and Ag⁺ plasma inside the solar cell module when the solar cell module works, and is very helpful to long-term operational stability of the device. Further, a thickness of the protective layer is 2 nm-100 nm, and the protective layer can protect device structure and efficiency.

Further, a thickness of the second inorganic layer is 10 nm-1000 nm. The second inorganic layer includes one or more of aluminum, silver, zinc, nickel, and magnesium. The second inorganic layer can react with oxygen in the air and generate a dense metal oxide protective layer so as to prevent the oxygen in the air from permeating into the module device.

It should be noted that the thickness of the first inorganic layer may be manufactured adaptively as 5 nm, 10 nm, 20 nm, 30 nm, 40 nm, 50 nm, 60 nm, 70 nm, 80 nm, 90 nm, 100 nm, 120 nm, 140 nm, 160 nm, 180 nm, 200 nm, etc. according to actual encapsulation demand, which will not be enumerated. The thickness of the protective layer may be manufactured adaptively as 2 nm, 5 nm, 10 nm, 20 nm, 30 nm, 40 nm, 50 nm, 60 nm, 70 nm, 80 nm, 90 nm, 100 nm, etc. according to actual encapsulation demand, which will not be enumerated. The thickness of the second inorganic layer may also be manufactured adaptively as 10 nm, 50 nm, 100 nm, 150 nm, 200 nm, 250 nm, 300 nm, 350 nm, 400 nm, 600 nm, 800 nm, 1000 nm, etc. according to actual encapsulation demand, which will not be enumerated.

Further, the perovskite solar cell module includes a hole transport layer, a perovskite layer, and an electron transport layer that are sequentially stacked on a transparent conductive glass substrate, and the first inorganic layer is located between the electron transport layer and the metal electrode layer.

In another aspect, the invention further provides an encapsulation method of an encapsulation layer structure of a perovskite solar cell module. The encapsulation method specifically includes:
step 1, pretreating a transparent conductive glass substrate;
step 2, sequentially manufacturing a hole transport layer, a perovskite layer, and an electron transport layer on the pretreated transparent conductive glass substrate;
step 3, performing evaporation method to form a first inorganic layer on the electron transport layer;
step 4, performing evaporation method to form a metal electrode layer on the first inorganic layer;
step 5, performing evaporation method to form a protective layer on the metal electrode layer; and
step 6, performing evaporation method to form a second inorganic layer on the protective layer and implementing encapsulation of the encapsulation layer structure;

Further, in step 1, the pretreating a transparent conductive glass substrate is as follows:
performing ultrasonic cleaning on the transparent conductive glass substrate, where an adopted cleaning solvent is a deionized water, an ITO cleaning solution, or anhydrous ethanol, an ultrasonic power is 800 W-1000 W, and ultrasonic time is 20 min-30 min; and
spraying nitrogen on a surface of a cleaned transparent conductive glass substrate evenly with a nitrogen gun, and performing ultraviolet ozone treatment on the transparent conductive glass substrate for 10 min-30 min.

Further, the evaporation in step 3, step 4, step 5 and step 6 are all performed in a vacuum evaporator.

In step 3, an air pressure in a chamber of the vacuum evaporator is controlled below 5×10⁻⁴ Pa, an evaporation current of 80 A-120 A is applied, an evaporation rate is 0.2 Å/s-0.5 Å/s, and the thickness of the first inorganic layer is 2 nm-200 nm. The low evaporation rate in this step can ensure that a sufficiently dense metal oxide layer is obtained so as to effectively achieve a barrier effect on moisture permeation and a blocking effect on the migration of I⁻ and Ag⁺ plasma.

In step 4, the air pressure in the chamber of the vacuum evaporator is controlled below 5×10⁻⁴ Pa, an evaporation current of 100 A-140 A is applied, the evaporation rate is 2.0 Å/s-10.0 Å/s, and the thickness of the metal electrode layer is 200 nm-400 nm.

In step 5, the air pressure in the chamber of the vacuum evaporator is controlled below 5×10⁻⁴ Pa, an evaporation current of 40 A-60 A is applied, the evaporation rate is 0.6 Å/s-1.2 Å/s, and the thickness of the protective layer is 2 nm-100 nm. The protective layer is used to prevent a metal electrode at a lower portion from being affected by an oxidation process of the second inorganic layer at an upper portion, so as to avoid decrease in overall power conversion efficiency of the module device. In addition, a formed dense layer can prevent moisture and oxygen from damaging a perovskite solar module.

In step 6, the air pressure in the chamber of the vacuum evaporator is controlled below 5×10⁻⁴ Pa, an evaporation current of 100 A-150 A is applied, the evaporation rate is 5.0 Å/s-15.0 Å/s, and the thickness of the second inorganic layer is 10 nm-1000 nm. The second inorganic layer has the great thickness so as to achieve an effect of fully establish a barrier against oxygen permeation from the air.

Compared with the art known to the inventors, the technical solution according to the invention has the following beneficial effects: the encapsulation layer structure designed by the invention is obtained by an evaporation method with a simple process flow, is easy to manufacture and reduces production cost. Specifically:
(1) The second inorganic layer at an uppermost portion of the perovskite solar cell module acts as a barrier against oxygen, and the protective layer between the second inorganic layer and the metal electrode layer protects device structure and efficiency.
(2) The first inorganic layer is arranged between the electron transport layer and the metal electrode layer, and can inhibit increase in defect state densities and non-radiative recombination caused by internal ion migration, increase an open-circuit voltage, play a positive role in improving power conversion efficiency of the perovskite solar cell module, and can act as a barrier against moisture.

In addition, the perovskite cell module encapsulated by the encapsulation method according to the invention greatly improves stability against the moisture and the oxygen, and also improves operational stability.

### Brief Description of the Drawings

The drawings herein are incorporated into the description as a constituent part of the description, and serve to explain principles of the invention along with the description.

To describe the technical solutions in examples of the invention more clearly, accompanying drawings required in explanations of the examples will be briefly introduced below. Apparently, a person skilled in the art can still derive other accompanying drawings from these accompanying drawings without creative efforts.
Fig. 1 illustrates a complete schematic diagram of an encapsulation layer structure of a perovskite solar cell module according to the invention;
Fig. 2 illustrates current density-voltage curves under standard solar illumination of perovskite solar cell modules manufactured in Example 1 and Comparative Example 1 of the invention;
Fig. 3 illustrates change diagrams of power conversion efficiency in an external air environment over time of perovskite solar cell modules manufactured in Example 1 and Comparative Example 1 of the invention;
Fig. 4 illustrates current density-voltage curves under standard solar illumination of perovskite solar cell modules manufactured in Example 2 and Comparative Example 2 of the invention; and
Fig. 5 illustrates change diagrams of power conversion efficiency in an external air environment over time of perovskite solar cell modules manufactured in Example 2 and Comparative Example 2 of the invention.

### Detailed Description of the Embodiments

Illustrative examples will be described in detail herein, and embodiments described in the following illustrative examples do not represent all embodiments consistent with the invention. On the contrary, these embodiments are merely instances that are consistent with some aspects of the invention, as detailed in the appended claims.

In order to make a person skilled in the art better understand the technical solution of the invention, the invention will be further described in detail below with reference to accompanying drawings and examples.

### Example 1

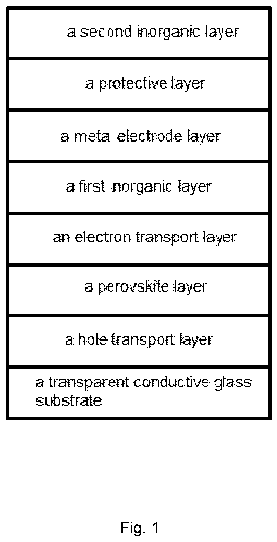

With reference to Fig 1, this example provides an encapsulation layer structure of a perovskite solar cell module. The encapsulation layer structure of a perovskite solar cell module includes: a first inorganic layer, a metal electrode layer, a protective layer, and a second inorganic layer that are sequentially stacked on the perovskite solar cell module.

The first inorganic layer is made from molybdenum oxide (MoOₓ), MoOₓ represents a mixture layer of MoO₂ and MoO₃, and a thickness of the first inorganic layer is 50 nm.

The metal electrode layer is made from Ag, and a thickness of the metal electrode layer is 300 nm.

The protective layer is made from lithium fluoride, and a thickness of the protective layer is 10 nm.

The second inorganic layer is made from aluminum, and a thickness of the second inorganic layer is 500 nm.

Specifically, the perovskite solar cell module includes a hole transport layer, a perovskite layer, and an electron transport layer that are sequentially stacked on a transparent conductive glass substrate, and the first inorganic layer is located between the electron transport layer and the metal electrode layer.

In addition, this example further provides an encapsulation method of an encapsulation layer structure of a perovskite solar cell module. The encapsulation method specifically includes:
Step 1, the transparent conductive glass substrate is pretreated: ultrasonic treatment is performed on the transparent conductive glass substrate in anhydrous ethanol at an ultrasonic power of 900 W for ultrasonic time of 20 min. Nitrogen is blown on a surface of the transparent conductive glass substrate evenly with a nitrogen gun, and ultraviolet ozone treatment is performed on the transparent conductive glass substrate for treatment time of 15 min.
Step 2, the hole transport layer, the perovskite layer, and the electron transport layer are sequentially manufactured on a pretreated transparent conductive glass substrate. A manufacturing process is the same as a conventional manufacturing process in the art, and will not be repeated herein.
Step 3, a manufactured perovskite solar cell module is placed in a vacuum evaporator, evaporation is performed to obtain a first inorganic layer (molybdenum oxide, that is, MoOₓ) on the electron transport layer, an air pressure in a chamber is pumped to a level below 5×10⁻⁴ Pa, an evaporation current of 100 A is applied, an evaporation rate is 0.3 Å/s, and an evaporation thickness (the thickness of the first inorganic layer) is 50 nm.
Step 4, evaporation is performed to form the metal electrode layer (Ag) on the first inorganic layer, the air pressure in the chamber is pumped to the level below 5×10⁻⁴ Pa, an evaporation current of 120 A is applied, the evaporation rate is 8 Å/s, and the evaporation thickness (the thickness of the metal electrode layer) is 300 nm.
Step 5, evaporation is performed to form the protective layer (lithium fluoride) on the metal electrode layer, the air pressure in the chamber is pumped to the level below 5×10⁻⁴ Pa, an evaporation current of 50 A is applied, the evaporation rate is 0.8 Å/s, and the evaporation thickness (the thickness of the protective layer) is 10 nm.
Step 6, evaporation is performed to form the second inorganic layer (aluminum) on the protective layer, the air pressure in the chamber is pumped to the level below 5×10⁻⁴ Pa, the evaporation current of 120 A is applied, the evaporation rate is 10 Å/s, and the evaporation thickness (the thickness of the second inorganic layer) is 500 nm.

After efficiency and stability tests, a perovskite cell module manufactured in this example has a maximum power conversion efficiency of 20.94%, and still maintains initial power conversion efficiency of 90% after placed in an external environment for 2400 h.

### Example 2

Some embodiments of this example are the same as some embodiments of Example 1 except for a difference in a material of the encapsulation layer structure. A material of the first inorganic layer is tungsten oxide (WOₓ), the tungsten oxide (WOₓ) is a mixture of WO₂ and WO₃, the protective layer is made from magnesium fluoride, and the second inorganic layer is made from magnesium.

After efficiency and stability tests, a perovskite cell module manufactured in this example has a maximum power conversion efficiency of 18.60%, and still maintains initial power conversion efficiency of 90% after placed in an external environment for 3600 h.

### Example 3

Some embodiments of this example are the same as the embodiments of Example 1 except for a difference in the material of the encapsulation layer structure. The material of the first inorganic layer is tungsten oxide (WOₓ), the tungsten oxide (WOₓ) is a mixture of WO₂ and WO₃, the protective layer is made from sodium fluoride, and the second inorganic layer is made from silver.

After efficiency and stability tests, a perovskite cell module device manufactured in this example has a maximum power conversion efficiency of 19.47%, and still maintains initial power conversion efficiency of 90% after placed in an external environment for 3200 h.

### Example 4

Some embodiments of this example are the same as the embodiments of Example 1 except for a difference in the material of the encapsulation layer structure. The material of the first inorganic layer is tungsten oxide (WOₓ), the tungsten oxide (WOₓ) is made from a mixture of WO₂ and WO₃, the protective layer is made from a mixture of calcium fluoride and sodium fluoride, and the second inorganic layer is made from zinc.

After efficiency and stability tests, a perovskite cell module device manufactured in this example has a maximum power conversion efficiency of 17.23%, and still maintains initial power conversion efficiency of 90% after placed in an external environment for 3000 h.

### Example 5

Some embodiments of this example are the same as the embodiments of Example 1 except for a difference in a thickness of the encapsulation layer structure. The thickness of the first inorganic layer is 100 nm, the thickness of the protective layer is 20 nm, and the thickness of the second inorganic layer is 800 nm.

After efficiency and stability tests, a perovskite cell module device manufactured in this example has a maximum power conversion efficiency of 16.89%, and still maintains initial power conversion efficiency of 90% after placed in an external environment for 3600 h.

### Example 6

Some embodiments of this example are the same as the embodiments of Example 1 except for a difference in the thickness of the encapsulation layer structure. The thickness of the first inorganic layer is 10 nm, the thickness of the protective layer is 2 nm, and the thickness of the second inorganic layer is 200 nm.

After efficiency and stability tests, a perovskite cell module device manufactured in this example has a maximum power conversion efficiency of 20.05%, and still maintains initial power conversion efficiency of 90% after placed in an external environment for 3600 h.

### Example 7

Some embodiments of this example are the same as the embodiments of Example 1 except for a difference in a manufacturing method of the perovskite solar cell module, and an evaporation rate of the first inorganic layer is 0.5 Å/s.

After efficiency and stability tests, a perovskite cell module device manufactured in this example has a maximum power conversion efficiency of 20.14%, and still maintains initial power conversion efficiency of 90% after placed in an external environment for 3600 h.

### Example 8

Some embodiments of this example are the same as the embodiments of Example 1 except for a difference in the manufacturing method of the perovskite solar cell module, and the evaporation rate of the first inorganic layer is 0.2 Å/s.

After efficiency and stability tests, a perovskite cell module device manufactured in this example has a maximum power conversion efficiency of 20.45%, and still maintains initial power conversion efficiency of 90% after placed in an external environment for 3200 h.

### Comparative Example 1

An encapsulation method of this example is the same as an encapsulation method of Example 1 except for a difference in that the encapsulation layer structure of a perovskite solar cell module includes the protective layer and the second inorganic layer that are on the metal electrode layer, and does not include the first inorganic layer between the electron transport layer and the metal electrode layer.

After efficiency and stability tests, a perovskite cell module device manufactured in this example has a maximum power conversion efficiency of 17.93%, and merely maintains initial power conversion efficiency of 60% after placed in an external environment for 2400 h.

### Comparative Example 2

An encapsulation method of this example is the same as an encapsulation method of Example 2 except for a difference in that the encapsulation layer structure of a perovskite solar cell module includes the first inorganic layer between the electron transport layer and the metal electrode layer, and the protective layer on the metal electrode layer, and does not include the second inorganic layer.

After efficiency and stability tests, a perovskite cell module device manufactured in this example has a maximum power conversion efficiency of 18.28%, and merely maintains initial power conversion efficiency of 60% after placed in an external environment for 2400 h.

### Comparative Example 3

An encapsulation method of this example is the same as the encapsulation method of Example 1 except for a difference in that the encapsulation layer structure of a perovskite solar cell module includes the first inorganic layer between the electron transport layer and the metal electrode layer, and the second inorganic layer on the metal electrode layer, and does not include the protective layer.

After efficiency and stability tests, a perovskite cell module device manufactured in this example has a maximum power conversion efficiency of 16.54%, and merely maintains initial power conversion efficiency of 60% after placed in an external environment for 1800 h.

### Comparative Example 4

An encapsulation method of this example is the same as the encapsulation method of Example 1 except for a difference in that the encapsulation layer structure of a perovskite solar cell module includes the first inorganic layer, the protective layer and the second inorganic layer that are sequentially disposed on the metal electrode layer from bottom to top. To be specific, the first inorganic layer is disposed on the metal electrode layer.

After efficiency and stability tests, a perovskite cell module manufactured in this example has a maximum power conversion efficiency of 16.89%, and merely maintains initial power conversion efficiency of 60% after placed in an external environment for 2000 h.

To sum up, an I-V curve test is performed on perovskite cell modules in Examples 1 to 2 and Comparative Examples 1 to 2 by a test method as follows:
An I-V curve (a photocurrent-voltage curve) uses a Si cell corrected by NREL to correct a light source density as 1 sun, and then the perovskite cell module is irradiated with a light source of a 450 W xenon lamp through an AM1.5 filter. An I-V curve of the cell is recorded with a digital multimeter, and an open-circuit voltage, a short-circuit current, a fill factor, and efficiency are computed according to the I-V curve.

PCE-t curves (curves of normalization efficiency change over time) are tested by a solar simulator. An illumination intensity of the solar simulator is 100 mA/cm², and experimental conditions include illumination at atmospheric pressure, a temperature of 20°C and humidity of 30%.

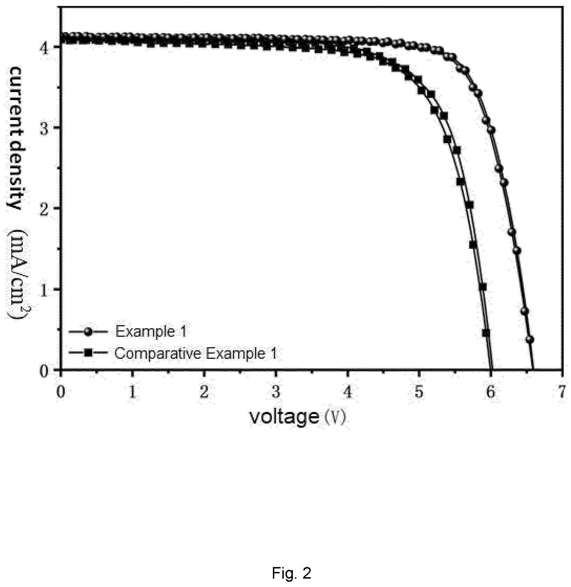

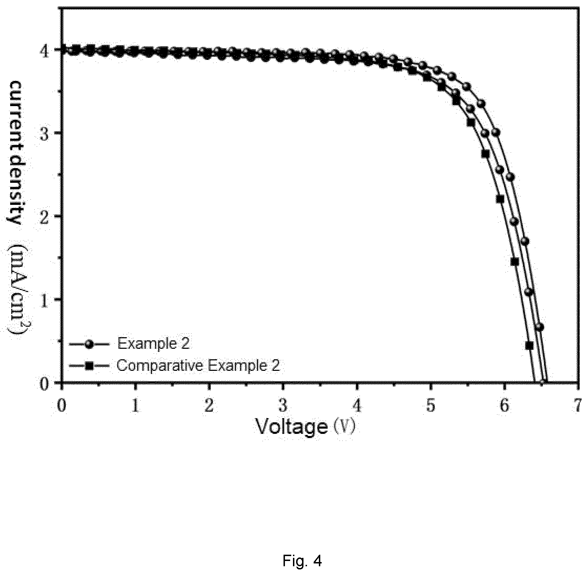

With reference to Fig. 2 and Fig. 4, parameters in Table 1 below can be computed.

**Table 1**

| Parameter | Example 1 | Comparative Example 1 | Example 2 | Comparative Example 2 |
|---|---|---|---|---|
| Open-circuit voltage/V | 6.582 | 5.994 | 6.521 | 6.408 |
| Short-circuit current density/mA/cm² | 4.13 | 4.09 | 3.98 | 4.01 |
| Fill factor % | 77.03 | 73.14 | 71.67 | 71.14 |
| Maximum power conversion efficiency % | 20.94 | 17.93 | 18.6 | 18.28 |

It can be seen from Table 1 that a perovskite cell module manufactured in Example 1 achieves maximum power conversion efficiency of 20.94% in a case of 6 sub-cells, with an open-circuit voltage of 6.582 V, a short-circuit current density of 4.13 mA/cm² and a fill factor of 77.03%. A corresponding perovskite cell module device manufactured in Comparative Example 1 achieves power conversion efficiency of 17.93% under the same conditions, with an open-circuit voltage of 5.994 V, a short-circuit current density of 4.09 mA/cm² and a fill factor of 73.14%. By comparing the parameters, it can be seen that addition of the first inorganic layer can inhibit increase in defect state densities and non-radiative recombination caused by internal ion migration, and further increase the open-circuit voltage. Thus, introduction of the first inorganic layer in the invention has a unique effect on increase in the power conversion efficiency of the perovskite solar cell module.

It can be seen from Table 1 that a perovskite module device manufactured in Example 2 achieves maximum power conversion efficiency of 18.60% in a case of 6 sub-cells, with an open-circuit voltage of 6.521V, a short-circuit current density of 3.98 mA/cm² and a fill factor of 71.67%. A corresponding perovskite cell module device manufactured in Comparative Example 2 achieves power conversion efficiency of 18.28% under the same conditions, with an open-circuit voltage of 6.408V, a short-circuit current density of 4.01mA/cm² and a fill factor of 71.14%. A slight difference in power conversion efficiency between Example 2 and Comparative Example 2 indicates that introduction of the second inorganic layer has little effect on the efficiency performance of the perovskite solar cell module, and a function of this layer is to improve stability of a device.

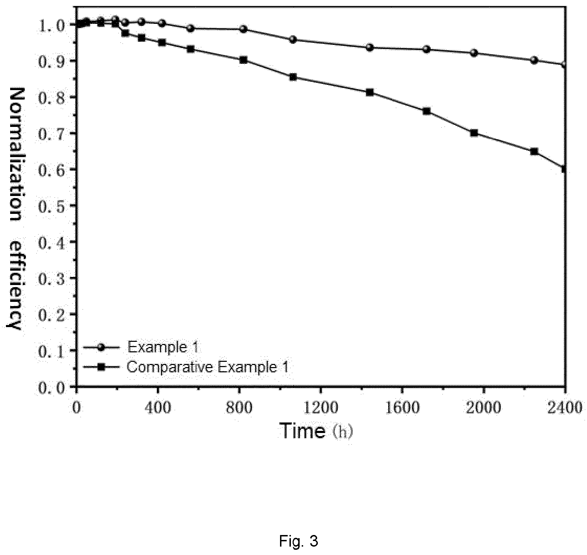

With reference to Fig. 3, it can be seen that the perovskite module manufactured in Example 1 still maintains initial power conversion efficiency of 90% after placed in an external air environment for 2400 h. However, the power conversion efficiency of the perovskite solar cell module in Comparative Example 1 decrease to 60% of an initial value. Through a comparison of the stability of the device, it can be seen that a function of the first inorganic layer to inhibit internal carrier migration plays a very important role in improving a stability of a cell device.

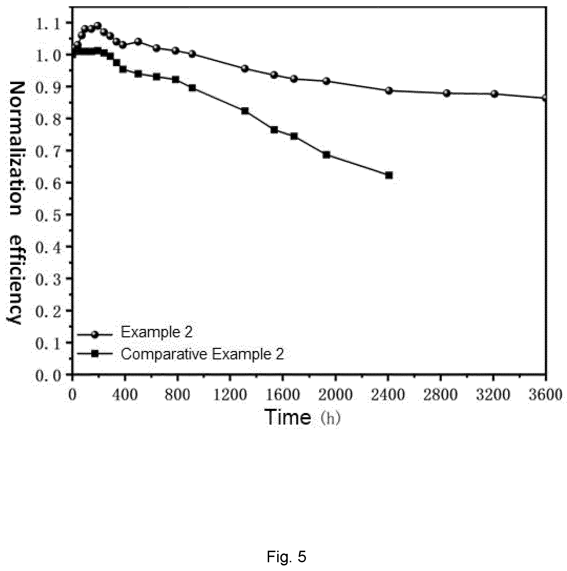

With reference to Fig. 5, it can be seen that the perovskite cell module with the second inorganic layer manufactured in Example 2 still has initial power conversion efficiency of 90% after placed in the air for 3600 h. However, a module device without the protection of the second inorganic layer in Comparative Example 2 has initial power conversion efficiency decreased to 60% after about 2400h. This comparison fully indicates a protective effect of the second inorganic layer on the stability of the device.

The embodiments described above are merely specific embodiments of the invention, and used by those skilled in the art to understand or implement the invention. Many modifications to these examples will be apparent to those skilled in the art, and the general principles defined herein can be implemented in other examples without departing from the spirit or scope of the invention.

It should be understood that the invention is not limited to contents described above, and various modifications and changes can be made without departing from the scope of the invention. The scope of the invention is merely limited by the appended claims.

## Claims

1. An encapsulation layer structure of a perovskite solar cell module, comprising: a first inorganic layer, a metal electrode layer, a protective layer, and a second inorganic layer that are sequentially stacked on the perovskite solar cell module; wherein
the protective layer is made from at least one of alkali metal fluoride or alkaline earth metal fluoride.

2. The encapsulation layer structure of a perovskite solar cell module according to claim 1, wherein the first inorganic layer is a metal oxide layer, and the metal oxide layer comprises one or a mixture of more of silicon oxide, zinc oxide, aluminum oxide, antimony trioxide, molybdenum oxide, tungsten oxide, indium oxide, tin oxide, and indium tin oxide.

3. The encapsulation layer structure of a perovskite solar cell module according to claim 1, wherein the second inorganic layer comprises one or more of aluminum, silver, zinc, nickel, and magnesium.

4. The encapsulation layer structure of a perovskite solar cell module according to claim 1, wherein a thickness of the first inorganic layer is 2 nm-200 nm.

5. The encapsulation layer structure of a perovskite solar cell module according to claim 1, wherein a thickness of the protective layer is 2 nm-100 nm.

6. The encapsulation layer structure of a perovskite solar cell module according to claim 1, wherein a thickness of the second inorganic layer is 10 nm-1000 nm.

7. The encapsulation layer structure of a perovskite solar cell module according to claim 1, wherein the first inorganic layer is made from a mixture of molybdenum dioxide and molybdenum trioxide, or a mixture of tungsten dioxide and tungsten trioxide.

8. The encapsulation layer structure of a perovskite solar cell module according to claim 1, wherein the perovskite solar cell module comprises a hole transport layer, a perovskite layer, and an electron transport layer that are sequentially stacked on a transparent conductive glass substrate, and the first inorganic layer is located between the electron transport layer and the metal electrode layer.

9. The encapsulation layer structure of a perovskite solar cell module according to claim 1, wherein the alkali metal fluoride comprises at least one of lithium fluoride, sodium fluoride, potassium fluoride, rubidium fluoride, and cesium fluoride, and the alkaline earth metal fluoride comprises at least one of beryllium fluoride, magnesium fluoride, calcium fluoride, strontium fluoride, and barium fluoride.

10. An encapsulation method of an encapsulation layer structure of a perovskite solar cell module, the encapsulation layer structure of a perovskite solar cell module according to any one of claims 1 to 9, specifically comprising:
step 1, pretreating a transparent conductive glass substrate;
step 2, sequentially manufacturing a hole transport layer, a perovskite layer, and an electron transport layer on the pretreated transparent conductive glass substrate;
step 3, performing evaporation method to form a first inorganic layer on the electron transport layer;
step 4, performing evaporation method to form a metal electrode layer on the first inorganic layer;
step 5, performing evaporation method to form a protective layer on the metal electrode layer; and
step 6, performing evaporation method to form a second inorganic layer on the protective layer and implementing encapsulation of the encapsulation layer structure.
